# FASCICULE DE BREVET EUROPEEN

(11) **EP 0 821 724 B1**
(45) Date de publication et mention de la délivrance du brevet: **01.03.2000**
(21) Numéro de dépôt: 96913601.9
(22) Date de dépôt: 17.04.1996
(51) Int. Cl.: C11D 7/24, C23G 5/024

(54) **AGENT DE NETTOYAGE A BASE DE CYCLOALCANES**
CYCLOALKANE ENTHALTENDES REINIGUNGSMITTEL
CYCLOALKANE-BASED CLEANING AGENT

(30) Priorité: 20.04.1995 FR 9504727
(43) Date de publication de la demande: 04.02.1998
(73) Titulaire: ELF ATOCHEM S.A., 92800 Puteaux, Hauts-de-Seine (FR)
(72) Inventeur: MICHAUD, Pascal, F-95210 Saint-Gratien (FR); MARTIN, Jean-Jacques, F-92270 Bois-Colombes (FR)
(86) Numéro de dépôt international: FR9600584
(87) Numéro de publication internationale: WO9633260

(56) Documents cités:
- EP-A- 0 255 871
- EP-A- 0 354 027
- EP-A- 0 474 053
- EP-A- 0 529 869
- WO-A-91/19831
- WO-A-93/06204
- WO-A-93/13246
- WO-A-95/10593
- DE-A- 3 316 988
- GB-A- 2 175 004
- GB-A- 2 266 725
- US-A- 5 399 282
- CHEMICAL ABSTRACTS, vol. 115, no. 16, 21 Octobre 1991 Columbus, Ohio, US; abstract no. 161650, page 137; XP002008544 & JP,A,03 062 896 (KAO CORP. ) 18 Mars 1991
- DATABASE WPI Section Ch, Week 8927 Derwent Publications Ltd., London, GB; Class A35, AN 89-195726 XP002008545 & JP,A,01 132 694 (ASAHI GLASS KK ) , 25 Mai 1989
- DATABASE WPI Section Ch, Week 9444 Derwent Publications Ltd., London, GB; Class D25, AN 94-354972 XP002008546 & JP,A,06 279 786 (ASAHI KASEI KOGYO KK) , 4 Octobre 1994

## Description

La présente invention concerne des cycloalcanes utilisables comme agents de nettoyage et de dégraissage, en machine et en milieu non aqueux de surfaces solides telles que les pièces métalliques, les céramiques, le verre, les matières plastiques ayant été souillées par des huiles ou des graisses d'usinage et/ou de leur protection temporaire.

Ces cycloalcanes sont également utilisables pour le défluxage des circuits imprimés. Cette opération de défluxage consiste à éliminer le flux de soudure.

Jusqu'à présent, on utilisait pour ces diverses opérations des solvants hydrocarbonés et principalement des solvants chlorés tels que notamment le 1,1,1-trichloroéthane connu dans le métier sous la désignation T 111, ainsi que des chlorofluoroalcanes tels que le 1,1,2-trichloro-1,2,2-trifluoréthane connu dans le métier sous la désignation F 113.

Cependant, ces composés chlorés et fluorochlorés sont suspectés être responsables de la diminution de la couche d'ozone stratosphérique qui assure une protection contre certaines radiations.

Suite au Protocole de Montréal qui résulte de récentes discussions internationales sur l'environnement, ces composés chlorés ou fluorochlorés devront à brève échéance être remplacés par des substituts ayant peu ou pas d'effet destructeur vis à vis d'ozone stratosphérique.

La demande de brevet Anglaise GB 2175004 propose une composition de nettoyage pour éliminer les graisses des surfaces métalliques ou plastiques comprenant de 85 à 97 parties en poids d'hydrocarbures non-aromatiques contenant des composés aliphatiques et/ou cycloaliphatiques et de 3 à 15 parties en poids de composés aromatiques contenant au moins un groupe alkyle ayant de 8 à 18 atomes de carbone.

Cependant, cette composition présente l'inconvénient de contenir des quantités non négligeables de composés aromatiques.

A cause notamment de leur caractère plus ou moins irritant l'utilisation de tels composés dans des applications de dégraissage se voit être de plus en plus limitée voir interdite.

La demande WO 91/19831 décrit une composition comprenant des cycloparaffines, des paraffines branchées et au moins un tensioactif.

La demande de brevet européen EP 0474053 décrit dans son exemple 1 une composition constituée par :
- 69 % en poids de cycloaparaffines,
- 29 % en poids d'isoparaffines,
- 2 % en poids de n-paraffines,
et des traces de composés aromatiques.

La demande WO 93/06204 concerne une composition constituée essentiellement de :
- 30 à 70 % en volume d'un ether glycol,
- 30 à 70 % en volume d'un ou plusieurs hydrocarbures aliphatiques linéaires, branchés ou cycliques ayant de 12 à 18 atomes de carbone,
- 0 à 10 % en volume d'au moins un tensio actif, et
- 0 à 5 % en volume d'au moins un inhibiteur, parfum ou colorant.

La demande WO 93/13246 concerne une composition comprenant :
i) de 75 à 90 parties en volume d'une fraction de distillation obtenue par distillation du pétrole, ladite fraction contenant pas moins de 92 % en poids, basé sur le poids total de la fraciton, d'hydrocarbures choisis parmi les hydrocarbures naphteniques et paraffiniques ayant de 8 à 15 atomes, et
ii) 5 à 25 parties en volume d'un ou plusieurs alcools aliphatiques saturés brachés ou non ayant de 5 à 15 atomes de carbone.

Le CHEMICAL ABSTRACTS, vol. 115, n° 16, n° 161650 concernant le JP-A-03062896 décrit une composition nettoyante contenant au moins 70 % en poids d'un hydrocarbure cyclique saturé ayant de 9 à 18 atomes de carbone et 0,1 à 30 % en poids d'un alcool aliphatique ayant de 6 à 18 atomes de carbone et/ou d'un agent tensioactif non ionique.

On a maintenant trouvé que l'on pouvait utiliser comme agent de nettoyage et de dégraissage des surfaces solides un cycloalcane pratiquement pur ou un mélange de cycloalcanes présentant un point d'éclair supérieur à 55° C mesuré selon la norme ASTM D56-70 et un intervalle de distillation allant de 175° C à 235° C, ledit mélange de cycloalcanes étant constitué par un mélange d'hydrocarbures saturés mono ou polycycliques, éventuellement substitués par un ou plusieurs restes alkyle; de formule générale

CₙH₂₍ₙ₊₁₋ₐ₎ (I)

dans laquelle n est un nombre entier allant de 8 à 12 et a un nombre entier allant de 1 à 5.

De préférence, on utilisera selon la présente invention un mélange de cycloalcanes de formule (I) dans laquelle n est un nombre entier allant de 9 à 11 et a est un nombre entier allant de 1 à 3.

A titre d'illustration de tels mélanges utilisables selon la présente invention, on peut citer les mélanges d'(alkyl)cycloalcanes obtenus par hydrogénation catalytique de coupes pétrolières constituées de composés aromatiques et/ou cyclodiéniques tels que notamment, les alkylbenzènes, les divinylbenzènes, le dicyclopentadiène, les alkyldicyclopentadiènes, le naphtalène et ses dérivés alkylés.

Les mélanges d'(alkyl)cycloalcanes ainsi obtenus sont essentiellement constitués d'hydrocarbures saturés cycliques pouvant avoir un ou plusieurs restes alkyle ayant de 1 à 4 atomes de carbone.

A titre d'illustration de tels mélanges, on peut citer les mélanges contenant deux ou plusieurs des composés ci-après : les tetrahydrodicyclopentadienes, les methyltetrahydrodicyclopentadienes, les dimethyltetrahydrodicyclopentadienes, les ethylpropylcyclohexanes, les alkyldécahydronaphtalènes.

Selon la présente invention, on utilisera de préférence des mélanges contenant au moins 40 % en poids d'endotetrahydrodicyclopentadiène.

Selon la présente invention, on peut également utiliser comme mélange de cycloalcanes des coupes pétrolières dites coupes naphténiques.

Ces coupes naphténiques sont essentiellement constituées par des composés de formule (I) dans laquelle a = 1, 2 ou 3 et n est généralement compris entre 9 à 12.

A titre d'exemple de telles coupes naphténiques, on peut citer les solvants naphténiques vendus par EXXON CHEMICAL sous la dénomination NAPPAR 11.

A titre d'exemples de cycloalcanes pratiquement purs, on peut citer le cyclodècane, le tricyclo [5.2.10.^{2,6}] décane, le bicyclohexyle.

Le mélange de cycloalcanes selon la présente invention présente l'avantage d'avoir des points d'éclair supérieurs à 55° C ce qui permet de l'utiliser sans danger dans les machines où l'on utilise des solvants dit A3, c'est à dire des solvants dont le point d'éclair est compris entre 55° C et 100° C.

De ce fait, le mélange de cycloalcanes de la présente invention peut être utilisé tout particulièrement dans des systèmes dits fermés dans lesquels les températures peuvent atteindre 40° C, voir plus, pour le nettoyage de surfaces solides telles que pièces métalliques et/ou plastiques et pour le défluxage des circuits imprimés.

Le mélange de cycloalcanes de la présente invention peut être stabilisé.

Comme stabilisants, on peut utiliser des dérivés nitrés tel que le nitrométhane, le nitroéthane, le nitropropane, le nitrotoluène ; des éthers ou des acétals tels que le diméthoxyméthane, le 1,3-dioxolane, le diméthoxyéthane; des amines telles que la triéthylamine, la dipropylamine, la diméthylamine ; des dérivés du phosphore tel que le triisodécylphoshite, le triisooctylphosphite.

Le mélange de cycloalcanes peut également contenir un ou plusieurs masquants d'odeur.

A titre d'exemple de tels produits, on peut citer la vanilline et ses dérivés, les essences de pin.

Ces composés sont utilisés en très faibles quantités, généralement comprises entre 0,01 et 0,1 partie en poids pour 100 parties en poids du mélange de cycloalcanes.

Le mélange selon l'invention présente l'avantage d'être facilement éliminé après l'opération de dégraissage.

Les exemples qui suivent illustrent l'invention.

Dans ces exemples, les points d'éclair sont déterminés selon la norme ASTM D56-70.

Les composés ci-après ont été utilisés :
◆ Les Napthènes "NAPPAR 11" (ci-après désigné par NAP 11). Cette coupe de cycloalcanes présente un intervalle de distillation allant de 182° C à 200° C et un point d'éclair de 60° C.
◆ Un mélange de cycloalcanes contenant environ 40 % en poids d'endo-tétrahydrodicyclopentadiene (ci-après désigné par THDCPD) présentant un intervalle de distillation allant de 180° C à 210° C et un point d'éclair de 58° C.

### Exemple 1

Une grille en inox de 40 x 30 mm est pesée après enduction avec une huile entière ou hydrosoluble fournie par CASTROL, SHELL, MOBIL ou ELF, et est dégraissée à une température d'environ 40° C par agitation mécanique dans un récipient contenant du NAP 11.

En 30 secondes, il ne reste plus aucune trace d'huile sur la grille.

### Exemple 2

On opère comme dans l'exemple 1 en remplaçant le NAP 11 par le THDCPD. Les performances de nettoyage sont identiques. En 30 secondes, la grille est totalement exemple d'huile.

### Exemple 3 (essai de défluxage)

Dans une petite machine de laboratoire bi-cuve équipée d'un générateur d'ultrasons, on introduit 125 ml de THDCPD dans chaque cuve, puis on porte le liquide de chaque cuve à 40° C.

Cinq circuits normalisés (modèle IPC-B-25) enduits de flux de soudure à base de colophane (flux R8F de la Société ALPHAMETAL) recuits à 230° C pendant 30 secondes et refroidis, sont immergés durant trois minutes dans le liquide à 40° C sous ultrasons. Les circuits sont égouttés pendant une minute, puis rincés pendant trois minutes dans la deuxième cuve et, ensuite à nouveau égouttés pendant une minute et finalement séchés à 55° C.

Le temps de séchage est de 75 secondes. La qualité du nettoyage est évaluée en déterminant le taux de résidu ionique selon la procédure normalisée IPC-TM 650 N° 2.3.25 et 2.3.26, et selon la norme MIL-STD-2000.

La valeur obtenue, 1,52 µg eq.NaCl/cm² est très inférieure au seuil (2,5 µg.ég.NaCl/cm²) toléré dans le domaine de l'électronique.

## Revendications

1. Utilisation comme agent de nettoyage et de dégraissage d'un cycloalcane pratiquement pur ou d'un mélange de cycloalcanes qui présente un point d'éclair supérieur à 55° C, mesuré selon la norme ASTM D56-70, et un intervalle de distillation allant de 175° C à 235° C, ledit mélange de cycloalcanes étant constitué par un mélange d'hydrocarbures saturés mono ou polycycliques, éventuellement substitués par un ou plusieurs restes alkyle, de formule générale
CₙH₂ (n + 1-a) (I)
dans laquelle n est un nombre entier allant de 8 à 12 et a un nombre entier allant de 1 à 5.

2. Utilisation selon la revendication 1, caractérisé en ce que dans la formule (I), n est un nombre entier allant de 9 à 11 et a est un nombre entier allant de 1 à 3.

3. Utilisation selon la revendication 1, caractérisée en ce que le mélange de cycloalcanes est un mélange contenant au moins 40 % en poids d'endo-tetrahydrodicyclopentadiene.

4. Utilisation selon la revendication 1 caractérisée en ce que le mélange de cycloalcanes est une coupe naphténique.

5. Utilisation selon la revendication 4, caractérisée en ce que la coupe naphténique est constituée essentiellement par des composés de formule (I) dans laquelle a = 1, 2 ou 3 et n est compris entre 9 et 12.

6. Application d'un mélange de cycloalcanes selon l'une des revendications 1 à 5 au nettoyage de surfaces solides.

7. Application selon la revendication 6 au défluxage des circuits imprimés et au dégraissage des pièces métalliques et/ou plastiques.

## Patentansprüche

1. Verwendung eines fast reinen Cycloalkans oder eines Gemisches aus Cyclo-alkanen, das einen Flammpunkt von mehr als 55 °C, gemessen nach der Norm ASTM D56-70, und einen Siedebereich von 175 °C bis 235 °C hat, wobei das genannte Cycloalkangemisch aus einem Gemisch aus gesättigten mono- oder polycyclischen, gegebenenfalls durch einen oder mehrere Alkylreste substituierten Kohlenwasserstoffen der allgemeinen Formel besteht
CₙH₂₍ₙ₊₁₋ₐ₎ (I)
in der n eine ganze Zahl von 8 bis 12 und a eine ganze Zahl von 1 bis 5 ist, als Reinigungs- und Entfettungsmittel.

2. Verwendung nach Anspruch 1, dadurch gekennzeichnet, daß in der Formel (I) n eine ganze Zahl von 9 bis 11 und a eine ganze Zahl von 1 bis 3 ist.

3. Verwendung nach Anspruch 1, dadurch gekennzeichnet, daß das Cycloalkangemisch ein Gemisch ist, das mindestens 40 Gew.-% Endo-Tetrahydrodicyclopentadien enthält.

4. Verwendung nach Anspruch 1, dadurch gekennzeichnet, daß das Cycloalkangemisch eine Naphthenfraktion ist.

5. Verwendung nach Anspruch 4, dadurch gekennzeichnet, daß die Naphthenfraktion im wesentlichen aus Verbindungen der Formel (I) bestellt, in der a = 1, 2 oder 3 ist und n zwischen 9 und 12 liegt.

6. Verwendung eines cycloalkangemisches nach einem der Ansprüche 1 bis 5 zur Reinigung fester Oberflächen.

7. Verwendung nach Anspruch 6 zur Flußmittelentfernung bei gedruckten Schaltungen und zum Entfetten von Metall- und/oder Plastikteilen.

## Claims

1. Use, as a cleaning and degreasing agent, of a virtually pure cycloalkane or a mixture of cycloalkanes which has a flashpoint above 55°C, measured according to ASTM standard D56-70, and a distillation range of from 175°C to 235°C, the said mixture of cycloalkanes being made up of a mixture of saturated mono- or polycyclic hydrocarbons, optionally substituted with one or more alkyl residues, of general formula
CₙH₂(n+1-a) (I)
in which n is an integer ranging from 8 to 12 and a is an integer ranging from 1 to 5.

2. Use according to Claim 1, characterized in that, in the formula (I), n is an integer ranging from 9 to 11 and a is an integer ranging from 1 to 3.

3. Use according to Claim 1, characterized in that the mixture of cycloalkanes is a mixture containing at least 40 % by weight of endo-tetrahydrodicyclopentadiene.

4. Use according to Claim 1, characterized in that the mixture of cycloalkanes is a naphthenic fraction.

5. Use according to Claim 4, characterized in that the naphthenic fraction consists essentially of compounds of formula (I) in which a = 1, 2 or 3 and n is between 9 and 12.

6. Application of a mixture of cycloalkanes according to one of Claims 1 to 5 to the cleaning of solid surfaces.

7. Application according to Claim 6, to the defluxing of printed circuits and to the degreasing of metal and/or plastic components.
